Europäisches Patentamt

(19) European Patent Office

Office européen des brevets

(11) Numéro de publication : **0 202 962 B1**

(12) **FASCICULE DE BREVET EUROPEEN**

(45) Date de publication du fascicule du brevet :
05.06.91 Bulletin 91/23

(51) Int. Cl.⁵ : **H03K 17/10**, H03K 17/14

(21) Numéro de dépôt : **86400680.4**

(22) Date de dépôt : **28.03.86**

(54) **Procédé de commande de l'instant d'ouverture d'au moins deux interrupteurs en série et circuit logique correspondant.**

(30) Priorité : **17.04.85 FR 8505760**

(43) Date de publication de la demande :
**26.11.86 Bulletin 86/48**

(45) Mention de la délivrance du brevet :
**05.06.91 Bulletin 91/23**

(84) Etats contractants désignés :
**AT BE CH DE FR GB IT LI LU NL SE**

(56) Documents cités :
**EP-A- 0 110 461
DE-A- 3 316 402
FR-A- 2 353 979
ELECTRONIQUE INDUSTRIELLE, no. 25, 1er décembre 1981, pages 31-35, Paris, FR; P. ITICSON: "Des transistors en série, une méthode originale pour la commutation haute tension"**

(73) Titulaire : **JEUMONT-SCHNEIDER INDUSTRIE
70, avenue du Président Wilson
F-92058 Paris la Défense Cedex 59 (FR)**

(72) Inventeur : **Andrejak, Jean-Marie
38, rue Palissy
F-77210 Avon (FR)**
Inventeur : **Foch, Henri
33, rue Tallien
F-31200 Toulouse (FR)**

(74) Mandataire : **Phélip, Bruno et al
c/o Cabinet Harlé & Phélip 21, rue de La Rochefoucauld
F-75009 Paris (FR)**

EP 0 202 962 B1

Jouve, 18, rue Saint-Denis, 75001 PARIS

## Description

La présente invention concerne les interrupteurs de puissance, notamment les hâcheurs, constitués par des transistors disposés en série.

De toute évidence, pour éviter que la tension appliquée entre le collecteur et l'émetteur de chacun des transistors monte à un niveau inadmissible pour le transistor considéré, il est nécessaire que tous les transistors se bloquent simultanément. En outre, en obtenant un blocage simultané des transistors en série, on obtient une économie sensible de l'énergie mise en oeuvre, puisqu'un tel blocage permet de réduire les pertes de puissance.

Le document DE-A-3 316 402 est relatif à un procédé et des dispositifs correspondants, applicables à un ensemble de thyristors en série et permettant de fermer tous les thyristors si l'un d'entre eux doit se bloquer trop rapidement. Ce procédé et ces dispositifs évitent bien aux thyristors d'avoir à supporter une surtension destructrice. Cependant, ils ne permettent pas de commander le blocage simultané de tous les thyristors. Ce sont essentiellement des moyens de protection et non des moyens de commande.

Le temps de blocage de chacun des transistors est essentiellement fonction des caractéristiques propres de ceux-ci et varie donc sur une plage de dispersion relativement importante d'un transistor à l'autre. La présente invention a donc pour but de décaler dans le temps le signal de commande de blocage d'un transistor de manière à ce que le blocage effectif du transistor soit obtenu à un instant déterminé.

Selon un premier aspect, la présente invention concerne un procédé de commande de l'ouverture d'au moins deux interrupteurs, à un instant déterminé.

Selon l'invention, pour chaque interrupteur, on cesse d'émettre l'ordre normal de fermeture desdits interrupteurs à un intervalle de temps déterminé avant cet instant déterminé, et l'on émet à la place un ordre additionnel de fermeture d'une durée égale à la différence entre cet intervalle et le temps réel requis par l'interrupteur pour passer de l'état fermé à l'état ouvert. De préférence, pour chaque interrupteur, le temps réel requis par l'interrupteur pour changer d'état est déterminé lors de ses précédents passages de l'état fermé à l'état ouvert. Ce temps réel est déterminé et mis en mémoire lors de chaque passage de l'état fermé à l'état ouvert.

Selon un autre de ses aspects, l'invention concerne un circuit logique de commande de l'ouverture d'au moins deux interrupteurs mis en série, à un instant déterminé.

Selon l'invention, ce circuit logique comprend un générateur d'un signal logique correspondant à l'ordre normal de fermeture desdits interrupteurs et, pour chaque interrupteur, un dispositif incluant une bascule monostable commandée par ledit signal logique et émettant une impulsion d'une durée déterminée en réponse à l'échelon correspondant à la cessation de l'ordre normal de fermeture, une porte OU aux deux entrées de laquelle sont respectivement appliqués le signal issu du générateur et le signal issu de la bascule monostable et dont le signal de sortie est appliqué à une première entrée d'un comparateur tandis que l'on applique à l'entrée de signe opposé dudit comparateur un signal logique représentatif de l'état réel de l'interrupteur, la borne de sortie du premier comparateur étant reliée à la borne d'entrée d'un circuit intégrateur dont la borne de sortie est reliée à une première borne d'entrée d'un deuxième circuit comparateur dont la seconde borne d'entrée, de polarité inverse, est reliée à la sortie d'un générateur de rampes commandé par la bascule monostable, le deuxième comparateur présentant sur sa borne de sortie un signal logique représentatif du signe de la différence des deux signaux qui lui sont appliqués en entrée, cette borne de sortie étant reliée à l'une des entrées d'une porte ET dont l'autre entrée est reliée à la sortie de la bascule monostable et dont le signal de sortie, ordre additionnel de fermeture, est appliqué à une entrée d'une porte OU à l'autre entrée de laquelle est appliqué le signal issu du générateur, le signal de sortie de ladite porte OU constituant le signal logique réel correspondant à l'ordre de fermeture de l'interrupteur.

L'invention sera mieux comprise et d'autres buts, avantages et caractéristiques de celle-ci apparaitront plus clairement à la lecture de la description qui suit d'un mode préféré de réalisation donnée à titre non limitatif et à laquelle une planche de dessins est annexée et sur laquelle :

La Figure 1 représente schématiquement un circuit logique conformément à la présente invention et,

la Figure 2 représente schématiquement la forme des signaux en fonction du temps en différents points du circuit représenté figure 1.

En référence maintenant aux Figures, le générateur 1 émet un signal logique A correspondant à l'ordre normal de fermeture de l'interrupteur non représenté ici, mais pouvant tout aussi bien être un transistor, un thyristor ou n'importe quel type de relais statique ou non.

L'échelon arrière de ce signal commande une bascule monostable 2 délivrant un créneau B d'une durée déterminée, par exemple de 20 microsecondes.

Ce créneau est appliqué, d'une part, à une porte OU 3, d'autre part à un générateur de rampes 4, et enfin à une porte ET 5.

La porte OU 3 a son autre entrée reliée au générateur 1, et sa sortie reliée à une entrée d'un premier comparateur 6 à l'autre entrée, de polarité opposée, duquel est appliqué un signal logique C représentant l'état réel de l'interrupteur.

Ce dernier signal C est, par exemple, obtenu en mesurant à tout instant la tension entre les broches de l'interrupteur et en engendrant un signal à l'état 1 lorsque cette tension est nulle, c'est-à-dire lorsque l'interrupteur est fermé, et un signal à l'état O lorsque cette tension est non-nulle, c'est-à-dire lorsque l'interrupteur est ouvert.

Le premier comparateur engendre donc, en sortie un signal D représentant, en signe et en durée, la différence des deux signaux qui lui sont appliqués en entrées.

Ce signal D est alors intégré de façon permanente au moyen du circuit intégrateur 7 dont le signal de sortie est référencé E.

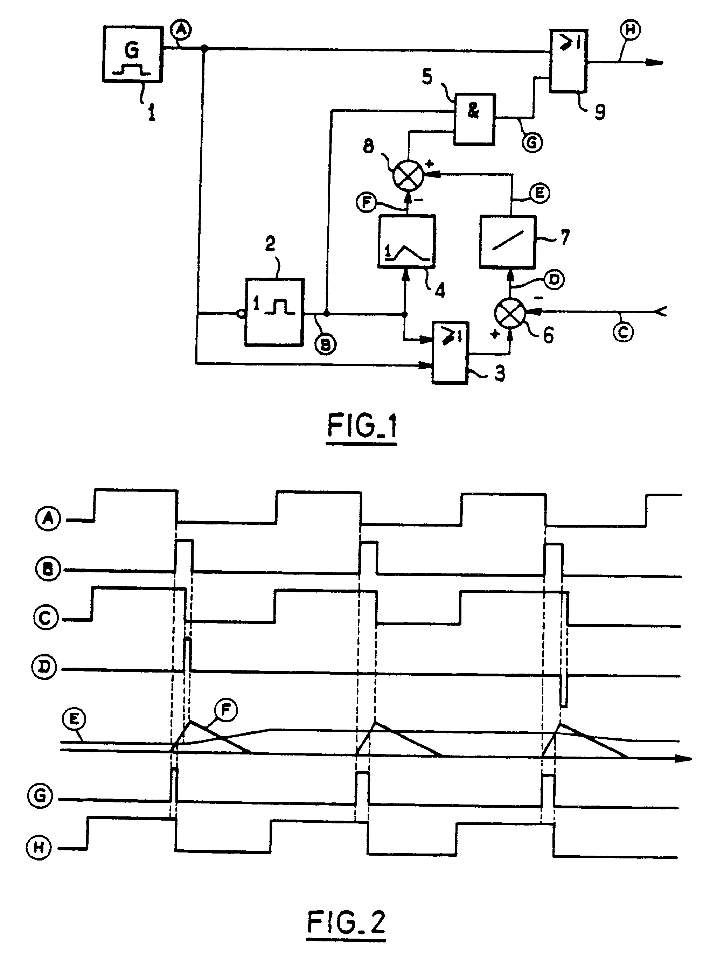

Pendant ce temps, le signal de sortie B de la bascule monostable 2 est appliqué au générateur de rampes 4 de caractéristiques bien déterminées et engendrant le signal référencé F Figure 2, présentant une porte déterminée.

Ces deux signaux E et F sont appliqués à un deuxième comparateur 8 engendrant un signal logique (non représenté sur la Figure) représentatif du signe de la différence des deux signaux E et F, à l'état 1 lorsque l'amplitude du signal E est supérieure à celle du signal F, à l'état O dans le cas contraire.

On comprend donc qu'en reliant la sortie de ce deuxième comparateur 8 à une entrée d'une porte ET 5 à l'autre entrée de laquelle est appliqué le signal B issu de la bascule monostable 2, on obtienne en sortie de cette porte ET une impulsion de largeur variable G correspondant à un ordre additionnel de fermeture de l'interrupteur, d'une durée égale à la différence entre la largeur du signal B issu de la bascule monostable 2 et le temps réel requis par l'interrupteur pour passer de l'état fermé à l'état ouvert. Ce temps réel est, en pratique, déterminé lors de chaque ouverture, mis en mémoire par l'intégrateur 7, et utilisé pour l'ouverture suivante lors de l'émission de l'ordre additionnel de fermeture de l'interrupteur.

Dans ce but, une porte OU 9 reçoit respectivement sur ses entrées le signal normal A issu du générateur 1 et le signal additionnel G issu de la porte ET 5, de telle manière que le signal de sortie H de cette porte OU 9 constitue le signal logique réel correspondant à l'ordre de fermeture de l'interrupteur.

Avec un tel circuit logique, après deux ou trois commutations successives, l'interrupteur s'ouvre systématiquement à l'échelon descendant du signal B, quelles que soient les caractéristiques propres de l'interrupteur.

Sur la Figure 2 on a représenté trois cycles de changements d'état de l'interrupteur. Au cours du premier cycle, à gauche, on constate que l'amplitude du signal E est, dans l'hypothèse considérée, relativement faible ; le signal additionnel en résultant G présente alors une courte durée. De ce fait, l'interrupteur va s'ouvrir (échelon descendant du signal C) avant le moment requis (échelon descendant du signal B issu de la bascule monostable 2). Il en résulte une impulsion positive D qui est appliquée à l'intégrateur 7 dont le signal de sortie présente alors une amplitude plus élevée. Lors du cycle suivant, le signal additionnel G résultant de la comparaison des amplitudes des signaux E et F, présente une plus grande durée, ce qui permet d'obtenir, dans l'exemple considéré, une coïncidence précise entre le moment déterminé pour l'ouverture de l'interrupteur (échelon descendant du signal B) et le moment réel de cette ouverture (échelon descendant du signal C). Le troisième cycle, représenté à droite sur la Figure 2, illustre le cas où l'ouverture réelle se produit après l'instant déterminé par l'échelon descendant du signal B. On constate qu'alors le signal D présente une polarité opposée et que l'amplitude du signal E de sortie du circuit intégrateur 7 diminue de manière consécutive, de telle sorte que la durée du signal additionnel G suivant (non représenté sur la Figure) soit inférieure à celle du signal additionnel précédent.

## Revendications

1. Procédé de commande de l'ouverture d'au moins deux interrupteurs mis en série, à un instant déterminé, caractérisé en ce que, pour chaque interrupteur, l'on cesse d'émettre l'ordre normal (A) de fermeture desdits interrupteurs à un intervalle de temps déterminé avant ledit instant déterminé, et que l'on émet à la place un ordre additionnel (G) de fermeture d'une durée égale à la différence entre ledit intervalle et le temps réel requis par ledit interrupteur pour passer de l'état fermé à l'état ouvert.

2. Procédé selon la revendication 1, caractérisé en ce que, pour chaque interrupteur, ledit temps réel requis par ledit interrupteur pour changer d'état est déterminé lors de ses précédents passages de l'état fermé à l'état ouvert.

3. Procédé selon la revendication 2, caractérisé en ce que, pour chaque interrupteur, ledit temps réel est déterminé et mis en mémoire lors de chaque passage de l'état fermé à l'état ouvert.

4. Circuit logique de commande de l'ouverture d'au moins deux interrupteurs mis en série, à un instant déterminé, caractérisé en ce qu'il comprend un générateur (1) d'un signal logique (A) correspondant à l'ordre normal de fermeture desdits interrupteurs et en ce qu'il comprend de plus, pour chaque interrupteur, un dispositif incluant une bascule monostable (2) commandée par le signal logique (A) et émettant une impulsion (B) d'une durée déterminée en réponse à l'échelon correspondant à la cessation de l'ordre normal de fermeture, une porte OU (3) aux deux entrées de laquelle sont respectivement appliqués le signal (A) issu du générateur (1) et le signal (B) issu de ladite bascule monostable (2) et dont le signal de sortie est appliqué à une première entrée d'un premier comparateur (6) tandis que l'on applique à l'entrée de signe opposé dudit comparateur un signal logique (C) représentatif de l'état réel dudit interrupteur, la borne de sortie dudit premier comparateur (6) étant reliée à la borne d'entrée d'un circuit intégrateur (7) dont la borne de sortie est reliée à une première borne d'entrée d'un deuxième circuit comparateur (8) dont la seconde borne d'entrée, de polarité inverse, est reliée à la sortie d'un générateur de rampes (4) commandé par ladite bascule monostable (2), ledit deuxième comparateur (8) présentant sur sa borne de sortie un signal logique représentatif du signe de la différence des deux signaux (E, F) qui lui sont appliqués en entrée, cette borne de sortie étant reliée à l'une des entrées d'une porte ET (5) dont l'autre entrée est reliée à la sortie de ladite bascule monostable (2) et dont le signal de sortie, ordre additionnel de fermeture (G), est appliqué à une entrée d'une porte OU (9) à l'autre entrée de laquelle est appliqué le signal (A) issu dudit générateur (1), le signal de sortie (H) de ladite porte OU (9) constituant le signal logique réel correspondant à l'ordre de fermeture dudit interrupteur.

## Claims

1. Process for controlling the opening of at least two switches in series at a specific moment, characterised in that, for each switch, the transmission of the normal instruction (A) for closing the said switches is interrupted at a specific interval before said specific moment and that instead an additional closing instruction (G) is transmitted of a length equal to the difference between said interval and the real tire required by the said switch to change from the closed state to the open state.

2. Process according to Claim 1, characterised in that, for each switch, the said real tire required by the said switch to change state is determined at its preceding change-overs from the closed state to the open state.

3. Process according to Claim 2, characterised in that, for each switch, the said real tire is determined and stored at each change-over from the closed state to the open state.

4. Logic control circuit for opening at least two switches in series at a specific moment, characterised in that it comprises a logic signal (A) generator (1) corresponding to the normal closing instruction of the said switches and in that it also comprises, for each switch, a device comprising a monostable flip-flop (2) controlled by the logic signal (A) and transmitting a pulse (B) of a determined length in response to the step corresponding to the extinction of the normal closing instruction, an OR gate (3), at the two inputs of which the signal (A) emitted by the generator (1) and the signal (B) emitted by the said monostable flip-flop (2) are respectively applied and the output signal of which is applied to a first input of a first comparator (6) whilst a logic signal (C) representing the real state of the said switch is applied to the input of opposite sign of the said comparator, the output terminal of the said first comparator (6) being connected to the input terminal of an integrator circuit (7), the output terminal of which is connected to a first input terminal of a second comparator circuit (8), the second input terminal of which, of reverse polarity, is connected to the output of a ramp generator (4) controlled by the said monostable flip-flop (2), the said second comparator (8) presenting at its output terminal a logic signal representing the sign of the difference between the two signals (E, F) which are applied to the input of said comparator, this output terminal being connected to one of the inputs of an AND gate (5), the other input of which is connected to the output of the said monostable flip-flop (2) and the output signal of which, the additional closing instruction (G), is applied to an input of an OR gate (9), at the other input of which the signal (A) emitted by the said generator (1) is applied, and the output signal (H) of the said OR gate (9) constituting the real logic signal corresponding to the closing instruction of the said switch.

## Ansprüche

1. Verfahren zum Steuern des Öffnens wenigstens zweier in Reihe geschalteter Unterbrecher zu einem bestimmten Zeitpunkt, dadurch gekennzeichnet, daß bei einem bestimmten Zeitintervall vor dem bestimmten Zeitpunkt das Aussenden des normalen Befehls (A) zum Schließen der Unterbrecher beendet wird und daß statt dessen ein zusätzlicher Befehl (G) zum Schließen ausgesendet wird, dessen Dauer gleich der Differenz zwischen dem Intervall und der tatsächlichen Zeit, die vom Unterbrecher für dessen Bewegung vom geschlossenen Zustand in den geöffneten Zustand benötigt wird, ist.

2. Verfahren gemäß Anspruch 1, dadurch gekennzeichnet, daß die von jedem Unterbrecher für die Zustandsänderung benötigte tatsächliche Zeit für jeden Unterbrecher während dessen vorhergehenden Bewegungen vom geschlossenen in den geöffneten Zustand bestimmt wird.

3. Verfahren gemäß Anspruch 2, dadurch gekennzeichnet, daß die tatsächliche Zeit für jeden Unterbrecher während jeder Bewegung vom geschlossenen Zustand in den geöffneten Zustand bestimmt und gespeichert wird.

4. Logikschaltung zum Steuern des Öffnens wenigstens zweier in Reihe geschalteter Unterbrecher zu einem bestimmten Zeitpunkt, dadurch gekennzeichnet, daß sie einen Generator (1) für ein Logiksignal (A), das dem normalen Befehl zum Schließen der Unterbrecher entspricht, aufweist und daß sie außerdem für jeden Unterbrecher eine Vorrichtung enthält, die umfaßt : eine monostabile Kippschaltung (2), die durch das Logiksignal (A) gesteuert wird und aufgrund einer dem Beenden des normalen Schließbefehls entsprechenden Signalstufe einen Impuls (B) von vorgegebener Dauer aussendet, ein ODER-Gatter (3), an dessen zwei Eingänge das vom Generator (1) ausgegebene Signal (A) bzw. das von der monostabilen Kippschaltung (2) ausgegebene Signal (B) angelegt werden und dessen Ausgangssignal an einen ersten Eingang eines ersten Komparators (6) angelegt wird, während an den invertierten Eingang des Komparators ein Logiksignal (C), das den tatsächlichen Zustand des Unterbrechers angibt, angelegt wird, wobei der Ausgangsanschluß des ersten Komparators (6) mit dem Eingangsanschluß einer Integrationsschaltung (7) verbunden ist, deren Ausgangsanschluß mit einem ersten Eingangsanschluß einer zweiten Komparatorschaltung (8) verbunden ist, deren zweiter Eingangsanschluß mit umgekehrter Polarität mit dem Ausgang eines Rampengenerators (4) verbunden ist, der von der monostabilen Kippschaltung (2) gesteuert wird, wobei der zweite Komparator (8) an seinem Ausgangsanschluß ein Logiksignal ausgibt, das das Vorzeichen der Differenz der zwei an seine Eingänge angelegten Signale (E, F) darstellt, wobei dieser Ausgangsanschluß mit einem der Eingänge eines UND-Gatters (5) verbunden ist, dessen anderer Eingang mit dem Ausgang der monostabilen Kippschaltung (2) verbunden ist und dessen Ausgangssignal, der zusätzliche Befehl zum Schließen (G), an einen Eingang eines ODER-Gatters (9) angelegt wird, an dessen anderen Eingang das vom Generator (1) ausgegebene Signal (A) angelegt wird, wobei der Ausgang (H) des ODER-Gatters (9) das dem Befehl zum Schließen des Unterbrechers entsprechende tatsächliche Logiksignal darstellt.

FIG.1

FIG.2